# FASCICULE DE BREVET EUROPEEN

(11) **EP 2 304 453 B1**
(45) Date de publication et mention de la délivrance du brevet: **08.08.2018**
(21) Numéro de dépôt: 09794021.7
(22) Date de dépôt: 23.06.2009
(51) Int. Cl.: G01R 31/28

(54) **SYSTEME ET PROCEDE DE DEVERMINAGE D'EQUIPEMENTS**
SYSTEM UND VERFAHREN ZUM EINBRENNEN VON GERÄTEN
EQUIPMENT BURN-IN METHOD AND SYSTEM

(30) Priorité: 30.06.2008 FR 0854374
(43) Date de publication de la demande: 06.04.2011
(73) Titulaire: Airbus Operations (Société par actions simplifiée), 31060 Toulouse (FR)
(72) Inventeur: ORTET, Stéphane, F-31700 Mondonville (FR)
(74) Mandataire: Gicquel, Olivier Yves Gérard
(86) Numéro de dépôt international: PCT/FR2009/051202
(87) Numéro de publication internationale: WO 2010/004165

(56) Documents cités:
- US-A- 5 819 208
- US-A1- 2002 075 024
- US-A1- 2003 037 193
- US-A1- 2006 259 203
- HARM C E ED - INSTITUTE OF ELECTRICAL AND ELECTRONICS ENGINEERS: "Real world application of burn-in to improve product quality" PROCEEDINGS OF THE INTERNATIONAL TELECOMMUNICATIONS ENERGY CONFERENCE. (INTELEC). KYOTO, NOV. 5 - 8, 1991; [PROCEEDINGS OF THE INTERNATIONAL TELECOMMUNICATIONS ENERGY CONFERENCE. (INTELEC)], NEW YORK, IEEE, US, vol. CONF. 13, 5 novembre 1991 (1991-11-05), pages 560-565, XP010040411 ISBN: 978-0-87942-670-5

## Description

La présente invention concerne un système et un procédé de déverminage d'équipements tels que des équipements électroniques et notamment des équipement avioniques.

Le déverminage a pour but de précipiter les défaillances latentes d'un système dans la phase de production. Dans le domaine de l'électronique, les défaillances se situent essentiellement au niveau des composants (circuit imprimé inclus) des soudures et du report des composants sur les circuits imprimés. Le document "Real world application of burn-in to improve product quality" (Harm C E - Thirteenth International Telecommunications Energy Conférence - INTELEC 1991) concerne le déverminage d'un équipement à température constante. Le déverminage peut porter sur plusieurs phénomènes physiques déverminage en vibration, résistance aux chocs, déverminage en température, .... La présente invention porte sur le déverminage en température par cyclage thermique.

Un des facteurs prépondérants dans l'efficacité du déverminage par cyclage thermique est la vitesse de variation de température lors des changements de température. Cette vitesse de variation doit être effective sur les composants internes constitutifs des équipements.

L'état de l'art consiste à utiliser des étuves avec des performances importantes pour appliquer à l'équipement des variations de température rapides.

En simplifiant, une étuve est une enceinte close isotherme embarquant un système de chauffage et un système de refroidissement. Le système de chauffage est de manière classique à base de résistances électriques.

Le système de refroidissement peut être de deux natures : une machine frigorifique comprenant un groupe froid, un évaporateur et un condenseur ou un système à base d'injection d'azote liquide dans l'étuve avec gazéification de l'azote dans l'étuve.

Pour des étuves dites VRT (Variation Rapide de Température), les valeurs de vitesse de variation peuvent aller de 10°C/min, alors qu'une étuve classique a des variations de 2°C/min, jusqu'à 60°C/min pour des machines très spécifiques.

Mais la problématique est qu'il n'est pas possible d'appliquer directement ces variations de température au niveau des éléments constitutifs de l'équipement.

En effet, les variations de température de l'étuve sont répercutées au niveau de l'équipement par échange de calories entre l'air de l'étuve et l'équipement.

Donc par principe, pour qu'il y ait échange thermique, il faut que l'air qui entoure l'équipement soit à une température différente de l'équipement. Plus il y a d'écart plus l'échange thermique est important. Le deuxième phénomène physique est l'inertie thermique de l'équipement qui s'oppose aux variations de température en stockant les calories.

Ces deux phénomènes combinés font qu'il y a un délai entre la variation de température de l'étuve et celle de l'équipement et un amortissement des pentes de variation.

Donc, pour une étuve donnée, pour une vitesse de variation de température donnée, plus l'inertie de l'équipement est grande et moins l'échange thermique est important et plus la vitesse de variation de température de l'équipement sera faible.

Pour améliorer le respect des vitesses de variation de température au niveau de l'équipement, il faut améliorer l'échange thermiques et trois solutions sont mises en oeuvre traditionnellement.

En premier il est connu de mettre les cartes électroniques directement en contact avec l'air de l'étuve ce qui impose de démonter partiellement l'équipement pour exposer les cartes.

Ceci à deux avantages : diminuer l'inertie thermique de l'équipement et favoriser l'échange thermique des cartes.

Ensuite, si l'équipement est ventilé, il est connu d'augmenter la ventilation. Le seul avantage de cette solution est de favoriser l'échange thermique entre l'air et les cartes électroniques ou l'équipement.

Enfin, la troisième solution est d'utiliser des étuves avec une capacité de variation de température importante et beaucoup plus grande que la vitesse de variation que l'on souhaite obtenir au niveau de la carte ou de l'équipement.

Ces trois solutions peuvent être mixées mais il reste que même avec un échange thermique parfait, les éléments constitutifs de l'équipement ne peuvent que suivre la température de l'étuve.

Donc la vitesse de variation de température atteignable est inférieure ou égale à la vitesse de variation de l'étuve. Dans la réalité, un écart important existe et l'étuve doit être fortement sur-dimensionnée.

De plus le déverminage étant réalisé en fin du processus de fabrication de l'équipement, ce dernier est complètement assemblé ce qui ne facilite pas l'échange thermique qui se fait essentiellement par convection au niveau des cartes électroniques dans le boîtier de l'équipement.

Il est connu d'ouvrir ou de démonter l'équipement pour mettre les cartes électroniques directement en contact avec l'air de l'étuve mais ceci cause un surcoût important lié à l'opération de démontage /remontage et comporte des risques associés de dégradation des cartes électroniques lors des manipulations. Cela a aussi un impact logistique.

Si on augmente le débit de ventilation, la répercussion au niveau des variations de températures dans l'équipement reste tout de même très inférieure à la consigne étuve.

L'utilisation d'étuves spécifiques dans lesquelles on utilise de l'azote liquide pour faire du froid, entraîne obligatoirement la mise à nue des cartes électroniques pour réaliser un échange thermique correct.

Au delà de l'impact sur le processus de fabrication, les coûts d'achat et d'exploitation liés à la grande consommation d'azote de ces étuves sont un inconvénient important.

La présente invention vise à offrir un moyen simplifié par rapport à l'art antérieur pour accroître les vitesses de variation de température tout en gardant un processus de déverminage simple réduisant voir annulant les besoins de démontage des équipements testés.

L'invention repose sur un principe revenant à suspendre le temps pendant les transitions, passage de chaud à froid et inversement, pour que vue de l'équipement la transition soit instantanée.

Pour ce faire la présente invention prévoit un procédé de déverminage d'un équipement selon la revendication 1. Avantageusement, on remet la ventilation de l'équipement en route en fin de ladite transition.

Non ventilé, l'équipement a peu d'échanges avec l'étuve ce qui laisse le temps à cette dernière de faire sa transition. Ainsi, lorsque la ventilation est remise en route, l'équipement est traversé par de l'air à une température ayant déjà varié alors que la température de l'équipement a très peu varié.

Avantageusement, on remet la ventilation en route à un débit supérieur au débit nominal de ventilation de l'équipement en sorte de forcer la ventilation de l'équipement.

Selon un premier mode de réalisation, le cycle possède au moins un palier chaud. Le palier chaud est dans ce cas préférablement à une température de l'ordre de 80°C.

Selon un mode de réalisation alternatif ou complémentaire, le cycle possède au moins un palier froid. Le palier froid est dans ce cas préférablement à une température de l'ordre de -40°C.

En partant du palier chaud on coupe avantageusement la ventilation avant le début de la descente et on prolonge la coupure jusqu'à obtenir un écart maximum entre la température de l'étuve et celle de l'équipement.

En partant du palier froid on coupe avantageusement la ventilation avant la remontée et on prolonge la coupure jusqu'à obtenir un écart maximum entre la température de l'étuve et celle de l'équipement.

Dans ce dernier cas, on coupe préférablement l'alimentation électrique de l'équipement avant et pendant le début de la remontée pour s'affranchir de l'élévation de température interne à l'équipement en fonctionnement.

Toujours selon l'invention, pour des remplissages partiels de l'étuve, on applique avantageusement, pour les transitions, une consigne étuve égale à la performance maximale atteinte quand l'étuve est pleine.

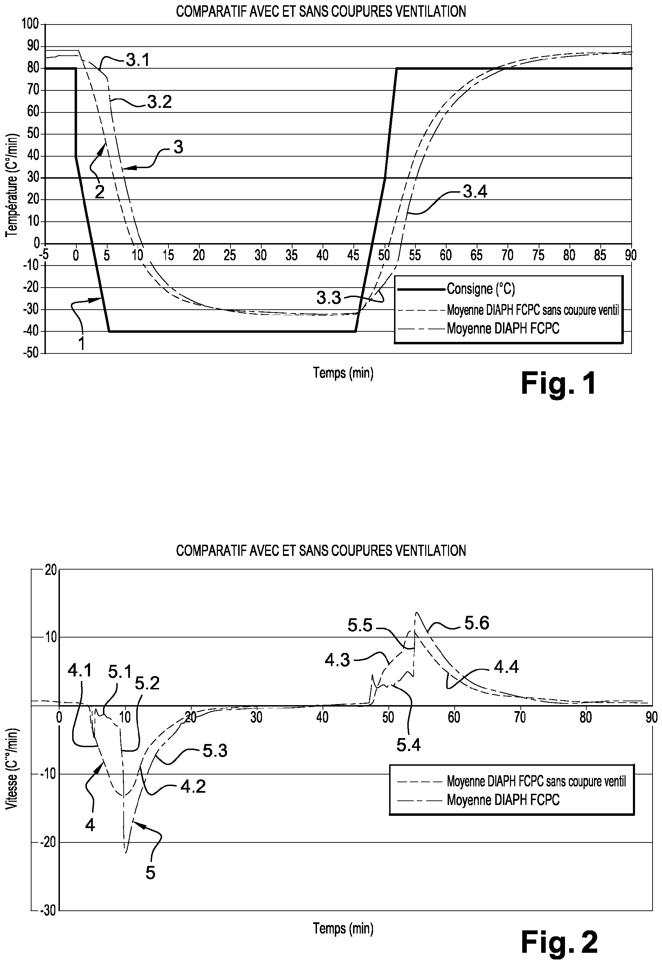

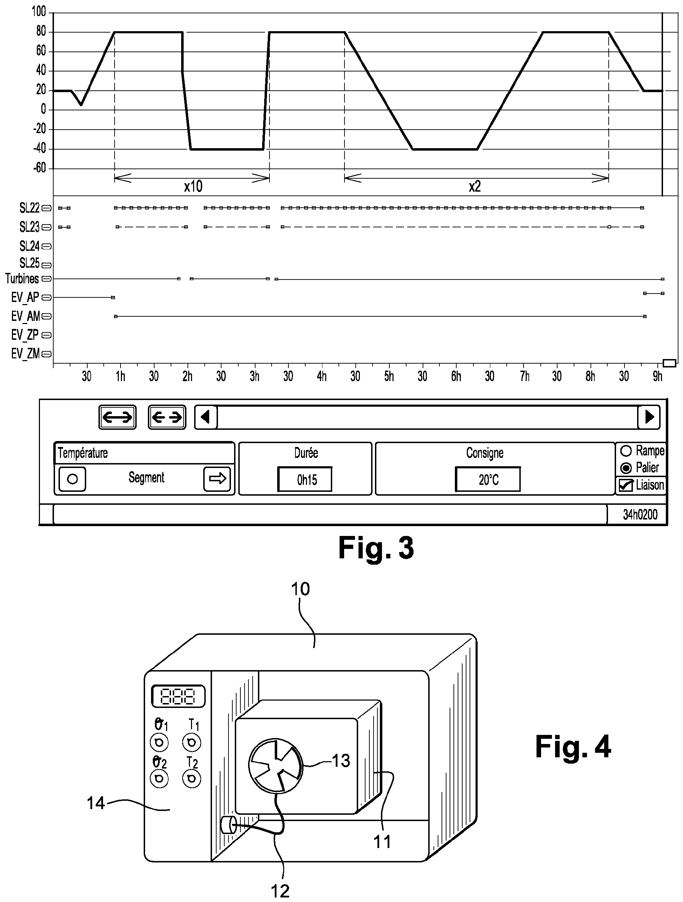

D'autres caractéristiques et avantages de l'invention seront apparents à la lecture de la description qui suit accompagnée des figures qui représentent:
en figure 1: un premier graphique représentant les variations de température en fonction du temps donnant un comparatif de montées et descentes de température avec et sans coupure de ventilation ;
en figure 2: un deuxième graphique représentant les vitesses de variation de température en fonction du temps et montrant les variations de pente de température avec et sans coupure de ventilation;
en figure 3: un troisième graphique représentant un exemple de processus de déverminage à multiples cycles de montée et de descente de température ;
en figure 4: une représentation schématique d'une étuve dans laquelle est disposé un équipement à tester.

L'invention s'applique au déverminage de cartes ou équipements électroniques par cyclage thermique.

La figure 4 représente une étuve dans le cadre du procédé selon l'invention munie d'un circuit de commande 12 relié à la ventilation 13 de l'équipement.

Le circuit de commande fait fonctionner la ventilation 13 en fonction des consignes de cyclage de l'étuve et est piloté par un contrôleur 14 qui comporte les consignes de cyclage.

Les cycles de déverminage VRT, possèdent au moins un palier chaud et un palier froid. Dans le cas d'équipements aéronautiques civils, des cycles avec des montées à 80°C et des descentes à -40°C sont courants et les exemples donnés pour l'invention se placent dans ce cadre.

La figure 1 représente le graphique de variation de température en fonction du temps.

Sont représentés sur cette figure:
- en trait plein, la température de consigne de l'étuve 1,
- en trait pointillé, la température de l'équipement sans coupure de ventilation 2 comme dans l'art antérieur et,
- en trait mixte, la température de l'équipement avec coupure de ventilation 3.

Selon l'invention, c'est à dire avec coupure de la ventilation, en partant du palier chaud, soit pour les temps de -5 à 0 minute dans l'exemple de la figure 1, on coupe la ventilation de l'équipement avant le début de la descente en température.

La descente en température de l'étuve repère 1 sur la figure 1 se fait en un temps de l'ordre de 5 minutes.

La durée de coupure de la ventilation va être réglée en fonction de la vitesse de descente de l'étuve et de l'inertie de l'équipement ce qui est représenté sur la courbe 3 pour laquelle une première pente de descente de température réduite 3.1 est visible en haut de la courbe. En effet, bien que non ventilé, l'équipement descend en température.

La remise en marche de la ventilation est réalisée lorsque l'écart entre le température de l'étuve et celle de l'équipement est maximum ce qui correspond au point d'inflexion entre les segments 3.1 et 3.2 de la courbe 3.

Lorsque la ventilation est remise en route, la température de l'équipement chute très rapidement avec une pente plus importante que pour la courbe 2 pour laquelle la ventilation de l'équipement est restée en fonction.

La pente comporte alors une partie très raide sur une majeure partie du segment 3.2 et est proche de la pente de transition de l'étuve vide.

Lors de la remontée, après 45 minutes, on coupe la ventilation au début de la transition.

On assiste à une légère remontée 3.3 pendant la coupure de la ventilation puis une courbe à forte pente 3.4 lors de la remise en route de cette ventilation.

Il est en outre dans ce cas intéressant de ne plus alimenter l'équipement avant et pendant le début de la remontée pour s'affranchir de son élévation de température interne, causée par la dissipation thermique des composants électroniques lorsqu'ils sont alimentés, ce qui réduit ou même fait disparaître la remontée 3.3.

En effet à -40°C de température étuve, les composants de l'équipement sont plus chauds car cet équipement dissipe de l'énergie.

Couper l'alimentation de l'équipement tout en le ventilant fait revenir sa température à -40°C.

Un dernier point à contrôler est la reproductibilité du déverminage. En effet, la performance de l'étuve est fonction de sa charge. Cette charge varie en fonction du rythme de production des équipements. La solution pour garantir une reproductibilité convenable quelque soit la charge de l'étuve est d'appliquer une consigne étuve (dans les montés et les descente) égale à la performance maximale atteinte quand l'étuve est pleine. Lorsque l'étuve sera pratiquement vide, elle suivra la même consigne que si elle était pleine.

L'étuve utilisée pour l'exemple est spécifiée pour atteindre des variations de température de 20°C/minute à vide.

On constate que lorsque la ventilation de l'équipement est en route lors des descentes et montées en température, la courbe 2 de descente et respectivement de montée a une pente de l'ordre de la moitié au quart de la pente de la consigne de l'étuve.

Lorsque la ventilation est coupée, courbe 3, un retard est introduit mais la pente est beaucoup plus raide et, en dehors de ses parties asymptotiques, est proche de la pente de consigne.

Les courbes correspondent à la valeur moyenne des températures au sein de l'équipement.

On remarque ainsi l'influence du procédé de l'invention sur les variations de température des composants. On peut aussi noter le décalage temporel lié à l'arrêt de la ventilation qui permet de rendre les pentes plus raides.

Le graphique de la figure 2 montre les vitesses de variation de température en fonction du temps, courbe 4 en trait pointillé pour l'équipement dont la ventilation reste en fonction et, courbe 5 en trait mixte pour l'équipement dont la ventilation est arrêtée lors des transitions.

Sur ce graphique les retards causés par l'arrêt de la ventilation sont particulièrement mis en évidence dans les parties de courbes 5.1 et 5.4. La remise en route de la ventilation est mise en évidence par les variations brutales des parties 5.2 et 5.5 de la courbe 5.

A contrario, sur la courbe 4 pour l'équipement dont la ventilation est maintenue, les variations de vitesse de changement de température de l'équipement sont plus faibles et plus amorties, les temps pendant lesquels la température varie sont pratiquement doublés alors que les taux de variation maximaux sont pratiquement divisés par deux.

Le procédé de l'invention permet ainsi de mieux répercuter les variations de température générées par l'étuve sur les dispositifs testés sans aucun coût supplémentaire autre que la commande de la ventilation de l'équipement.

Donc pour un même niveau de stress, qui dépend de la vitesse de variation de la température, appliqué à l'équipement on peut utiliser une étuve moins performante donc d'un prix significativement inférieur.

A l'inverse avec une étuve performante on peut appliquer des stress plus importants qui peuvent être équivalents à ceux que l'on appliquerait avec les étuves les plus performantes du marché actuel sans utiliser l'invention.

Si l'on regarde un cas concret d'implémentation, où il est nécessaire d'appliquer des variations de température de 20°C/min sur les équipements, comme dans l'exemple de cyclage connu de la figure 3, le procédé de l'invention permet d'utiliser des étuves classiques à 20°C/min sans démonter l'équipement.

Il y a donc une optimisation de l'utilisation de l'étuve puisqu'il n'est alors pas nécessaire d'utiliser une étuve de performances supérieures.

Pour améliorer encore la vitesse de variation, il faut lorsque l'on remet la ventilation en fonction, le faire de manière importante.

L'invention n'est pas limitée à l'exemple représenté et est notamment applicable à des cycles comportant des seuils de température différents.

## Revendications

1. Procédé de déverminage d'un équipement pourvu d'une ventilation comportant une étape de passage en étuve de l'équipement avec des cycles comportant au moins une transition de montée en température et/ou de descente en température de l'étuve, **caractérisé en ce qu'**on pilote la ventilation de l'équipement par un contrôleur (14) en fonction des consignes de cyclage de l'étuve et on coupe la ventilation de l'équipement pendant au moins une partie d'une transition en température de l'étuve.

2. Procédé de déverminage selon la revendication 1, **caractérisé en ce qu'**on remet la ventilation de l'équipement en route en fin de ladite transition.

3. Procédé de déverminage d'un équipement selon la revendication 2, **caractérisé en ce qu'**on remet la ventilation en route à un débit supérieur au débit nominal de ventilation de l'équipement en sorte de forcer la ventilation de l'équipement.

4. Procédé de déverminage d'un équipement selon la revendication 1, 2 ou 3 **caractérisé en ce que** le cycle possède au moins un palier chaud.

5. Procédé de déverminage d'un équipement selon la revendication 4 **caractérisé en ce que** ledit palier chaud est à une température de l'ordre de 80°C.

6. Procédé de déverminage d'un équipement selon l'une des revendications 1 à 5 **caractérisé en ce que** le cycle possède au moins un palier froid.

7. Procédé de déverminage d'un équipement selon la revendication 6 , **caractérisé en ce que** ledit palier froid est à une température de l'ordre de -40°C.

8. Procédé de déverminage d'un équipement selon la revendication 4, **caractérisé en ce que**, en partant du palier chaud, on coupe la ventilation avant le début de la descente et on prolonge la coupure jusqu'à obtenir un écart maximum entre la température de l'étuve et celle de l'équipement.

9. Procédé de déverminage d'un équipement selon la revendication 6, **caractérisé en ce que**, en partant du palier froid, on coupe la ventilation avant la remontée et on prolonge la coupure jusqu'à obtenir un écart maximum entre la température de l'étuve et celle de l'équipement.

10. Procédé de déverminage d'un équipement selon la revendication 6 ou 9, **caractérisé en ce qu'**on coupe l'alimentation électrique de l'équipement avant et pendant le début de la remonté pour s'affranchir de l'élévation de température interne à l'équipement.

## Patentansprüche

1. Verfahren zum Einbrennen eines Geräts, das mit einer Belüftung versehen ist, umfassend einen Schritt der Ofentrocknung mit Zyklen, umfassend mindestens einen Übergang eines Temperaturanstiegs und/oder eines Temperaturabfalls des Ofens, **dadurch gekennzeichnet, dass** die Belüftung des Geräts durch einen Kontroller (14) in Abhängigkeit von Zyklussollwerten des Ofens gesteuert wird, und die Belüftung des Geräts während mindestens eines Teils eines Temperaturübergangs des Ofens unterbrochen wird.

2. Verfahren zum Einbrennen nach Anspruch 1, **dadurch gekennzeichnet, dass** die Belüftung des Geräts am Ende des Übergangs wieder in Gang gesetzt wird.

3. Verfahren zum Einbrennen eines Geräts nach Anspruch 2, **dadurch gekennzeichnet, dass** die Belüftung mit einer größeren Belüftungsmenge als die Nominalmenge des Geräts wieder in Gang gesetzt wird, um die Belüftung des Geräts zu forcieren.

4. Verfahren zum Einbrennen eines Geräts nach Anspruch 1, 2 oder 3, **dadurch gekennzeichnet, dass** der Zyklus mindestens ein heißes Lager besitzt.

5. Verfahren zum Einbrennen nach Anspruch 4, **dadurch gekennzeichnet, dass** das heiße Lager auf einer Temperatur von ungefähr 80 °C ist.

6. Verfahren zum Einbrennen eines Geräts nach einem der Ansprüche 1 bis 5, **dadurch gekennzeichnet, dass** der Zyklus mindestens ein kaltes Lager besitzt.

7. Verfahren zum Einbrennen eines Geräts nach Anspruch 6, **dadurch gekennzeichnet, dass** das kalte Lager auf einer Temperatur von ungefähr -40 °C ist.

8. Verfahren zum Einbrennen eines Geräts nach Anspruch 4, **dadurch gekennzeichnet, dass** ausgehend von dem heißen Lager die Belüftung vor dem Beginn des Abfalls unterbrochen wird, und die Unterbrechung verlängert wird, bis ein maximaler Abstand zwischen der Temperatur des Ofens und jener des Geräts erhalten wird.

9. Verfahren zum Einbrennen nach Anspruch 6, **dadurch gekennzeichnet, dass** ausgehend von dem kalten Lager die Belüftung vor dem Wiederanstieg unterbrochen wird, und die Unterbrechung verlängert wird, bis ein maximaler Abstand zwischen der Temperatur des Ofens und jener des Geräts erhalten wird.

10. Verfahren zum Einbrennen eines Geräts nach Anspruch 6 oder 9, **dadurch gekennzeichnet, dass** die Stromversorgung des Geräts vor und während des Beginns des Wiederanstiegs unterbrochen wird, um die Temperaturerhöhung innerhalb des Geräts zu vermeiden.

## Claims

1. Method for burning in a piece of equipment that is provided with a fan, including a step of exposing the piece of equipment to cycles in an environmental chamber, said cycles including at least one transition, namely a rise in the temperature and/or drop in the temperature of the environmental chamber, **characterized in that** the fan of the piece of equipment is controlled with a controller (14) to reflect environmental-chamber cycle set points, and the fan of the piece of equipment is stopped during at least part of one environmental-chamber temperature transition.

2. Burning-in method according to Claim 1, **characterized in that** the fan of the piece of equipment is restarted at the end of said transition.

3. Method for burning in a piece of equipment according to Claim 2, **characterized in that** the fan is restarted with a speed higher than the nominal fan speed of the piece of equipment so as to force the ventilation of the piece of equipment.

4. Method for burning in a piece of equipment according to Claim 1, 2 or 3, **characterized in that** the cycle has at least one hot plateau.

5. Method for burning in a piece of equipment according to Claim 4, **characterized in that** said hot plateau is at a temperature of about 80°C.

6. Method for burning in a piece of equipment according to one of Claims 1 to 5, **characterized in that** the cycle has at least one cold plateau.

7. Method for burning in a piece of equipment according to Claim 6, **characterized in that** said cold plateau is at a temperature of about -40°C.

8. Method for burning in a piece of equipment according to Claim 4, **characterized in that**, starting from the hot plateau, the fan is stopped before the start of the drop and the stoppage is prolonged until a maximum difference between the temperature of the environmental chamber and the temperature of the piece of equipment is obtained.

9. Method for burning in a piece of equipment according to Claim 6, **characterized in that**, starting from the cold plateau, the fan is stopped before the rise and the stoppage is prolonged until a maximum difference between the temperature of the environmental chamber and the temperature of the piece of equipment is obtained.

10. Method for burning in a piece of equipment according to Claim 6 or 9, **characterized in that** the supply of electrical power to the piece of equipment is stopped before and during the start of the rise, in order to prevent an increase in temperature internal to the piece of equipment.
